# EUROPEAN PATENT APPLICATION

(11) **EP 1 385 034 A1**
(43) Date of publication of application: **28.01.2004**
(21) Application number: 03016356.2
(22) Date of filing: 18.07.2003
(51) Int. Cl.: G02B 7/182

(54) **Adaptive lithography mirror with actuators**

(30) Priority: 23.07.2002 US 398539 P; 29.05.2003 US 448613
(71) Applicant: Nikon Corporation, Tokyo 100-8331 (JP)
(72) Inventor: Watson, Douglas C., Campbell, California 95008 (US)
(74) Representative: Viering, Jentschura & Partner

(57) **Abstract**

A deformable mirror arrangement (10) has a plurality of constraint mechanisms (30) contacting a deformable mirror (20) at specified contact positions. At least three of these constraint mechanisms are rigid body servo control mechanisms such as high-bandwidth servo control mechanisms, each including a force actuator (30) contacting the mirror (20) at a position corresponding to one of the contact positions, a position sensor (42) assisting to measure position of the mirror (20) and a servo control unit (45) for controlling the force actuator.

## Description

### BACKGROUND OF THE INVENTION

This invention is in the technical field of rigid body control of a deformable mirror and more particularly to rigid body control of a deformable mirror with high-bandwidth servo.

It has been known to support a deformable mirror, and more particularly a thin-membrane mirror, by means of many high-stiffness actuators such as PZT actuators, as described, for example, in U.S. Patent 5,037,184 issued August 6, 1991 to Ealey. These many actuators overconstrain the mirror, and overconstrained mirrors have disadvantages for precision control.

Deformable mirrors with low-stiffness force-type actuators for controlling deformation without overconstraint were disclosed by John Hardy ("Active Optics: A New Technology for the Control of Light," IEEE, Vol. 60, No. 6 (1978)) but high-stiffness kinematic mounts are used for controlling the position in six degrees of freedom. Kinematically constrained deformable mirrors with force actuators require some other means for controlling or adjusting the rigid body position.

### SUMMARY OF THE INVENTION

It is therefore an object of this invention to provide a method of precisely controlling the rigid body positions of a deformable mirror.

It is another object of the invention to provide a deformable mirror arrangement for precisely controlling the rigid body positions of a deformable mirror.

It is still another object of this invention to provide a lithography system incorporating an optical system including such a deformable mirror arrangement and a method of precisely controlling the rigid body positions of its deformable mirror.

A deformable mirror arrangement embodying this invention may be characterized as comprising a deformable mirror and a plurality of constraint mechanisms contacting the mirror at specified contact positions, at least three of these constraint mechanisms being rigid body servo control mechanisms such as high-bandwidth servo control mechanisms each including a force actuator contacting the mirror at a corresponding one of the contact positions, a position sensor for detecting the corresponding contact position and a servo control unit for controlling the force actuator. The three rigid body servo control mechanisms may apply parallel constraints on the mirror perpendicularly (along the Z-axis) to the mirror surface to control rigid body degrees of freedom along the Z-axis and around the X- and Y-axes which are perpendicular to the Z-axis. The remaining three of the six rigid body degrees of freedom may be controlled by flexures or other conventional mechanical means.

A control method and a lithography system of this invention are characterized as using a mirror arrangement as described above. The invention also relates to a method of lithography characterized as using a system embodying this invention and products obtained by such a production method.

### BRIEF DESCRIPTION OF THE DRAWING

The invention, together with further objects and advantages thereof, may best be understood with reference to the following description taken in conjunction with the accompanying drawings in which:
Fig. 1A is a cross-sectional schematic view of a lithographic exposure apparatus incorporating at least one deformable mirror arrangement of this invention;
Fig. 1B is a schematic optical diagram of a representative embodiment of an X-ray microlithography system comprising at least one deformable mirror arrangement according to any of the embodiments of this invention, Fig. 1C is a detailed view of the projection-optical system of the microlithography system shown in Fig. 1B, and Fig. 1D is a schematic optical diagram of another representative embodiment of an X-ray microlithography system comprising at least one deformable mirror arrangement (including a reflective reticle) according to any of the embodiments of this invention;
Fig. 2 is a process flow diagram illustrating an exemplary process by which semiconductor devices are fabricated by using the apparatus shown in Figs. 1A, 1B or 1D according to the present invention;
Fig. 3 is a flowchart of the wafer processing step shown in Fig. 2 in the case of fabricating semiconductor devices according to the present invention;
Fig. 4 is a schematic side view of a deformable mirror arrangement;
Fig. 5 is a block diagram of a high-bandwidth servo shown in Fig. 4; and
Fig. 6 schematically shows a manner in which rigid body constraints may be applied to a deformable mirror.

### DETAILED DESCRIPTION OF THE INVENTION

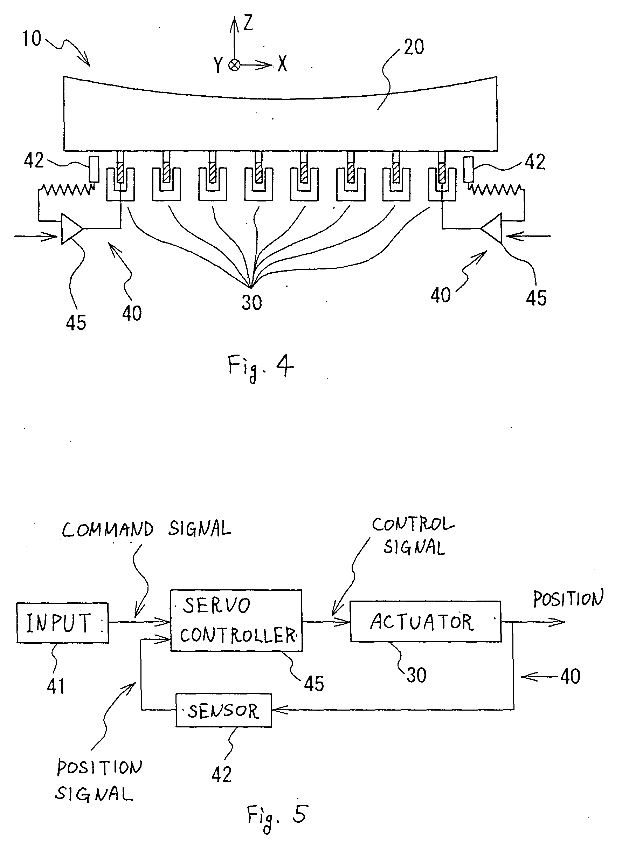

Fig. 4 shows very schematically a deformable mirror arrangement 10 embodying this invention with a deformable mirror 20 supported by many low-stiffness actuators 30 at as many positions on its back surface for locally deforming the mirror 20. These actuators 30 may be passive or actively controlled. Examples of passive actuators include soft springs of which preload is adjusted with screws or other position actuators. Examples of actively controlled force actuators include voice coil motors (VCMs), pneumatic actuators and EI-core actuators.

Some or all of the six rigid-body degrees of freedom of the mirror 20 are controlled by high-bandwidth servos-controlled actuators. For the convenience of illustration, Fig. 4 shows only two high-bandwidth servos 40 but the mirror arrangement 10 according to this invention include at least three high-bandwidth servos 40 for adjusting at least three rigid body positions. Each of the at least three high-bandwidth servos 40 includes one of the actively controlled force actuators 30, a high-precision sensor 42 and a servo controller 45.

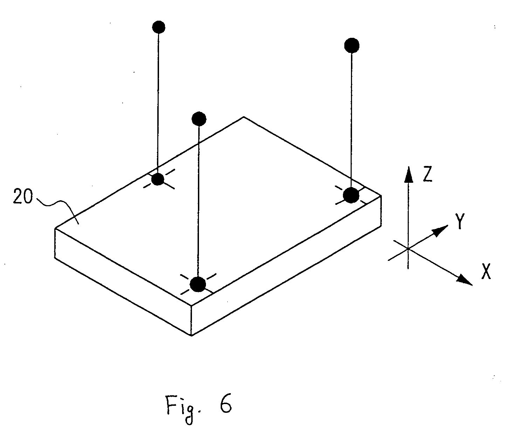

As shown in Fig. 5, the servo controller 45 is adapted to receive from an inputting device 41 a command signal indicative of a desired mirror position, or the target position. The sensor 42 measures and outputs a position signal indicative of the present position of the associated actuator 30, that is, the present position of the portion of the mirror 20 contacting the actuator 30. The servo controller 45 compares the command signal with the position signal and outputs a control signal to the actuator 30. The actuator is thereby activated. In the meantime, the sensor 42 continuously monitors the position of the actuator 30 so that the actuator 30 maintains the target position indicated by the command signal.

For the convenience of description, a coordinate system is defined as shown in Fig. 4 with the direction perpendicular to the backside of the mirror 20 designated as the Z -axis. The X-axis and the Y-axis are defined to be perpendicular to each other and both perpendicular to the Z-axis. According to a preferred embodiment of the invention, the aforementioned at least three high-bandwidth servos 40 contact the mirror 20 so as to control its deformation along the Z-axis (piston), around the X-axis (tip) and around the γ-axis (tilt). The remaining three rigid body degrees of freedom around the Z-axis (yaw), along the X-axis and along the Y-axis may be constrained by flexures or other conventional mechanical means. The invention does not prevent these three other rigid body degrees of freedom constrained by similar position servo controls.

Those of the force actuators 30 used in connection with the servos 40 may be the same as, similar to or different from those that are not being used in connection with any of the servos 40 but merely for deforming the mirror 20. Those of the force actuators 30 used in connection with the servos 40 may contact any part of the mirror, not only on the backside but also on the perimeter, as illustrated in Fig. 6.

Fig. 6 shows an example in which the three servo-controlled actuators 30 apply parallel constraints on the mirror 20 along the Z-axis, the remaining actuators being not shown for clarity. In order to effectively constrain the three rigid body degrees of freedom along the Z-axis, around the X-axis and around the Y-axis, the three parallel constraints must define a triangle of an appreciable size relative to the dimensions of the mirror 20. The remaining three constraints (on the three remaining rigid body degrees of freedom) may be positioned according to a pattem such as shown in Fig. 6.

Throughout herein, the term "mirror" is intended to be interpreted in the broadest sense of the word given in dictionaries such as "a surface able to reflect enough undiffused light to form a virtual image of an object placed before it." Thus, the object of constraint, as described above, need not be limited to a deformable mirror but may be a lens. Basically, the same concepts presented herein are applicable also to a refractive lens although care must be taken in this application such that all contacts and actuators must be outside the clear aperture of the lens so as to allow the light to pass through unobstructed.

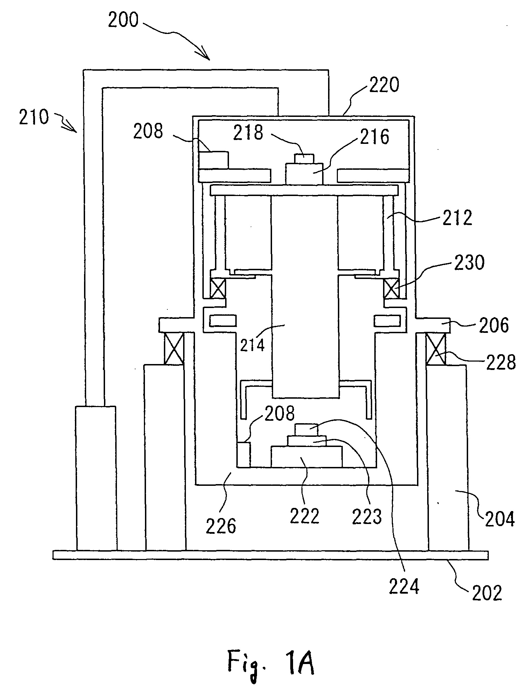

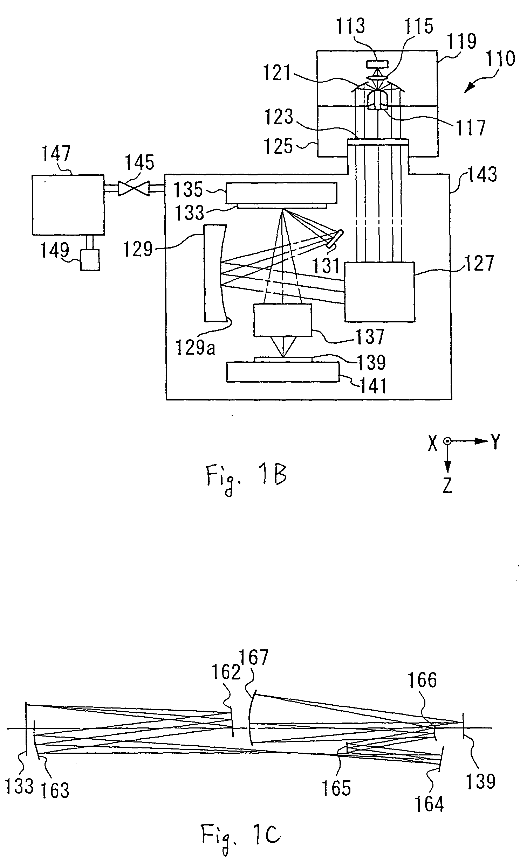

Fig. 1A shows a typical lithographic exposure apparatus 200 incorporating the deformable mirror arrangement of this invention, comprising a mounting base 202, a support frame 204, a base frame 206, a measurement system 208, a control system (not shown), an illumination system 210, an optical frame 212, an optical device 214 which may include the deformable mirror, a reticle stage 216 for retaining a reticle 218, an upper enclosure 220 surrounding the reticle stage 216, a wafer stage 222, a wafer table 223 for retaining a semiconductor wafer workpiece 224, and a lower enclosure 226 surrounding the wafer stage 222.

The support frame 204 typically supports the base frame 206 above the mounting base 202 through a base vibration isolation system 228. The base frame 206 in turn supports, through an optical vibration isolation system 230, the optical frame 212, the measurement system 208, the reticle stage 216, the upper enclosure 220, the optical device 214, the wafer stage 222, the wafer table 223 and the lower enclosure 226 above the base frame 206. The optical frame 212 in turn supports the optical device 214 and the reticle stage 216 above the base frame 206 through the optical vibration isolation system 230. As a result, the optical frame 212, the components supported thereby and the base frame 206 are effectively attached in series through the base vibration isolation system 228 and the optical vibration isolation system 230 to the mounting base 202. The vibration isolation systems 228 and 230 are designed to damp and isolate vibrations between components of the exposure apparatus 200 and comprise a vibration damping device. The measurement system 208 monitors the positions of the stages 216 and 222 relative to a reference such as the optical device 214 and outputs position data to the control system. The optical device 214 typically includes a lens assembly that projects and/or focuses the light or beam from the illumination system 210 that passes through the reticle 218. The reticle stage 216 is attached to one or more movers (not shown) directed by the control system to precisely position the reticle 218 relative to the optical device 214. Similarly, the wafer stage 222 includes one or more movers (not shown) to precisely position the wafer workpiece 224 with the wafer table 223 relative to the optical device (lens assembly) 214.

As will be appreciated by those skilled in the art, there are a number of different types of photolithographic devices. For example, exposure apparatus 200 can be used as a scanning type photolithography system, which exposes the pattern from reticle 218 onto wafer 224 with reticle 218, and wafer 224 moving synchronously. In a scanning type lithographic device, reticle 218 is moved perpendicular to an optic al axis of optical device 214 by reticle stage 216 and wafer 224 is moved perpendicular to an optical axis of optical device 214 by wafer stage 222. Scanning of reticle 218 and wafer 224 occurs while reticle 218 and wafer 224 are moving synchronously.

Alternatively, exposure apparatus 200 can be a step-and-repeat type photolithography system that exposes reticle 218 while reticle 218 and wafer 224 are stationary. In the step and repeat process, wafer 224 is in a constant position relative to reticle 218 and optical device 214 during the exposure of an individual field. Subsequently, between consecutive exposure steps, wafer 224 is consecutively moved by wafer stage 222 perpendicular to the optical axis of optical device 214 so that the next field of semiconductor wafer 224 is brought into position relative to optical device 214 and reticle 218 for exposure. Following this process, the images on reticle 218 are sequentially exposed onto the fields of wafer 224 so that the next field of semiconductor wafer 224 is brought into position relative to optical device 214 and reticle 218.

However, the use of exposure apparatus 200 provided herein is not limited to a photolithography system for a semiconductor manufacturing. Exposure apparatus 200, for example, can be used as an LCD photolithography system that exposes a liquid crystal display device pattern onto a rectangular glass plate or a photolithography system for manufacturing a thin film magnetic head. Additionally, the present invention provided herein can be used in other devices, including other semiconductor p rocessing equipment, machine tools, metal cutting machines, and inspection machines.

The illumination source (of illumination system 210) can b e g-line (436 nm), i-line (365 nm), KrF excimer laser (248 nm), ArF excimer laser (193 nm) and F₂ laser (157 nm). Alternatively, the illumination source can also use x-ray.

With respect to optical device 214, when far ultra-violet rays such as the excimer laser is used, glass materials such as quartz and fluorite that transmit far ultra-violet rays is preferably used. When the F₂ type laser or x-ray is used, optical device 214 should preferably be either catadioptric or refractive (a reticle should also preferably be a reflective type).

Also, with an exposure device that employs vacuum ultra-violet radiation (VUV) of wavelength 200 nm or lower, use of the catadioptric type optical system can be considered. Examples of the catadioptric type of optical system include the disclosure Japan Patent Application Disclosure No. 8-171054 published in the Official Gazette for Laid-Open Patent Applications and its counterpart U.S. Patent No. 5,668,672, as well as Japan Patent Application Disclosure No. 10-20195 and its counterpart U.S. Patent No. 5,835,275. In these cases, the reflecting optical device can be a catadioptric optical system incorporating a beam splitter and concave mirror. Japan Patent Application Disclosure No. 8-334695 published in the Official Gazette for Laid-Open Patent Applications and its counterpart U.S. Patent No. 5,689,377 as well as Japan Patent Application Disclosure No. 10-3039 and its counterpart U.S. Patent No. 5,892,117 also use a reflecting-refracting type of optical system incorporating a concave mirror, etc., but without a beam splitter, and can also be employed with this invention. The disclosures in the above mentioned U.S. patents, as well as the Japan patent applications published in the Official Gazette for Laid-Open Patent Applications are incorporated herein by reference.

Further, in photolithography systems, when linear motors (see U.S. Patent Nos. 5,623,853 or 5,528,118) are used in a wafer stage or a reticle stage, the linear motors can be either an air levitation type employing air bearings or a magnetic levitation type using Lorentz force or reactance force. Additionally, the stage could move along a guide, or it could be a guideless type stage which uses no guide. The disclosures in U.S. Patent Nos. 5,623,853 and 5,528,118 are incorporated herein by reference.

Alternatively, one of the stages could be driven by a planar motor, which drives the stage by electromagnetic force generated by a magnet unit having two-dimensionally arranged magnets and an armature coil unit having two-dimensionally arranged coils in facing positions. With this type of driving system, either one of the magnet unit or the armature coil unit is connected to the stage and the other unit is mounted on the moving plane side of the stage.

Movement of the stages as described above generates reaction forces which can affect performance of the photolithography system. Reaction forces generated by the wafer (substrate) stage motion can be mechanically released to the floor (ground) by use of a frame member as described in U.S. Patent No. 5,528,118 and published Japanese Patent Application Disclosure No. 8-166475. Additionally, reaction forces generated by the reticle (mask) stage motion can be mechanically released to the floor (ground) by use of a frame member as described in U.S. Patent No. 5,874,820 and published Japanese Patent Application Disclosure No. 8-330224. The disclosures in U.S. Patent Nos. 5,528,118 and 5,874,820 and Japanese Patent Application Disclosure No. 8-330224 are incorporated herein by reference.

As described above, a photolithography system according to the above described embodiments can be built by assembling various subsystems, including each element listed in the appended claims, in such a manner that prescribed mechanical accuracy, electrical accuracy and optical accuracy are maintained. In order to maintain the various accuracies, prior to and following assembly, every optical system is adjusted to achieve its optical accuracy. Similarly, every mechanical system and every electrical system are adjusted to achieve their respective mechanical and electrical accuracies. The process of assembling each subsystem into a photolithography system includes mechanical interfaces, electrical circuit wiring connections and air pressure plumbing connections between each subsystem. Needless to say, there is also a process where each subsystem is assembled prior to assembling a photolithography system from the various subsystems. Once a photolithography system is assembled using the various subsystems, total adjustment is performed to make sure that every accuracy is maintained in the complete photolithography system. Additionally, it is desirable to manufacture an exposure system in a clean room where the temperature and humidity are controlled.

Fig.1B shows an EUV (or soft-X-ray SXR) system 110, including the EUV mirror of this invention as described above. As a lithographic energy beam, the EUV system 110 uses a beam of EUV light of wavelength λ = 13 nm. The depicted system is configured to perform microlithographic exposures in a step-and-scan manner.

The EUV beam is produced by a laser-plasma source 117 excited by a laser 113 situated at the most upstream end of the depicted system 110. The laser 113 generates laser light at a wavelength within the range of near-infrared to visible. For example, the laser 113 can be a YAG laser or an excimer laser. Laser light emitted from the laser 113 is condensed by a condensing optical system 115 and directed to the downstream laser-plasma source 117. Upon receiving the laser light, the laser-plasma source 117 generates SXR (EUV) radiation having a wavelength (λ) of approximately 13 nm with good efficiency.

A nozzle (not shown), disposed near the laser-plasma source 117, discharges xenon gas in a manner such that the discharged xenon gas is irradiated with the laser light in the laser-plasma source 117. The laser light heats the discharged xenon gas to a temperature sufficiently high to produce a plasma that emits photons of EUV light as the irradiated xenon atoms transition to a lower-potential state. Since EUV light has low transmittance in air, the optical path for EUV light propagating from the laser-plasma source 117 is contained in a vacuum chamber 119 normally evacuated to high vacuum. Since debris normally is produced in the vicinity of the nozzle discharging xenon gas, the vacuum chamber 119 desirably is separate from other chambers of the system.

A parabolic mirror 121, coated with a Mo/Si multilayer film, is disposed relative to the laser-plasma source 117 so as to receive EUV light radiating from the laser-plasma source 117 and to reflect the EUV light in a downstream direction as a collimated beam. The multilayer film on the parabolic mirror 121 is configured to have high reflectivity for EUV light of which λ = approximately 13 nm.

The collimated beam passes through a visible-light-blocking filter 123 situated downstream of the parabolic mirror 121. By way of example, the filter 123 is made of Be, with a thickness of 150 nm. Of the EUV radiation reflected by the parabolic mirror 121, only the desired 13-nm wavelength of radiation passes through the filter 123. The filter 123 is contained in a vacuum chamber 125 evacuated to high vacuum.

An exposure chamber 143 is disposed downstream of the filter 123. The exposure chamber 143 contains an illumination-optical system 127 that comprises a condenser mirror and a fly-eye mirror (not shown, but well understood in the art). The illumination-optical system 127 also is configured to trim the EUV beam (propagating from the filter 123) to have an arc-shaped transverse profile. The shaped "illumination beam" is irradiated toward the left in the figure.

A circular, concave mirror 129 is situated so as to receive the illumination beam from the illumination-optical system 127. The concave mirror 129 has a parabolic reflective surface 129a and is mounted perpendicularly in the vacuum chamber 143. The concave mirror 129 comprises, for example, a quartz mirror substrate of which the reflection surface is machined extremely accurately to the desired parabolic configuration. The reflection surface of the mirror substrate is coated with a Mo/Si multilayer film so as to form the reflective surface 129a that is highly reflective to EUV radiation of which λ = 13 nm. Alternatively, for other wavelengths in the range of 10-15 nm, the multilayer film can be of a first substance such as Ru (ruthenium) or Rh (rhodium) and a second substance such as Si, Be (Beryllium) or B₄C (carbon tetraboride).

A mirror 131 is situated at an angle relative to the concave mirror 129 so as to received the EUV beam from the concave mirror 129 and direct the beam at a low angle of incidence to a reflective reticle 133. The reticle 133 is disposed horizontally so that its reflective surface faces downward in the figure. Thus, the beam of EUV radiation emitted from the illumination-optical system 127 is reflected and condensed by the concave mirror 129, directed by the mirror 131, and focused don the reflective surface of the reticle 133.

The reticle 133 includes a multilayer film so as to be highly reflective to incident EUV light. A reticle pattern, corresponding to the pattern to be transferred to a substrate 139, is defined in an EUV-absorbing layer formed on the multiplayer film of the reticle 133, as discussed later below. The reticle 133 is mounted via a reticle chuck on a reticle stage 135 that moves the reticle 133 at least in the Y direction. The reticle 133 normally is too large to be illuminated entirely during a single exposure "shot" of the EUV beam. As a result of the mobility of the reticle stage 135, successive regions of the reticle 133 can be irradiated sequentially so as to illuminate the pattern in a progressive manner with EUV light from the mirror 131.

A projection-optical system 137 and substrate (such as a semiconductor wafer) 139 are disposed in that order downstream of the reticle 133. The projection -optical system 137 comprises multiple multilayer-film reflective mirrors that collectively demagnify an aerial image of the illuminated portion of the pattern on the reticle 133. The demagnification normally is according to a predetermined demagnification factor such as 1/4. The projection-optical system 137 focuses an aerial image of the illuminated pattern portion onto the surface of the substrate 139. Meanwhile, the substrate 139 is mounted via a wafer (substrate) chuck on a substrate stage 141 that is movable in the X, Y, and Z directions.

Connected to the exposure chamber 143 via a gate valve 145 is a preliminary-evacuation ("load-lock") chamber 147. The load-lock chamber 147 allows exchanges of the reticle 133 and/or substrate 139 as required. The load -lock chamber 147 is connected to a vacuum pump 149 that evacuates the load-lock chamber 147 to a vacuum level substantially equal to the vacuum level inside the exposure chamber 143.

During a micro lithographic exposure, EUV light from the illumination-optical system 127 irradiates the reflective surface of the reticle 133. Meanwhile, the reticle 133 and substrate 139 are moved by their respective stages 135 and 141 in a synchronous manner relative to the projection-optical system 137. The stages 135 and 141 move the reticle 133 and the substrate 139, respectively, at a velocity ratio determined by the demagnification factor of the projection-optical system 137. Thus, the entire circuit pattern defined don the reticle 133 is transferred, in a step-and-scan manner, to one or more "die" or "chip" locations on the substrate 139. By way of example, each "die" or "chip" on the substrate 139 is a square having 25-mm sides. The pattern is thus" transferred" from the reticle 133 to the substrate at very high resolution (such as sufficient to resolve a 0.07 µm line-and-space (L/S) pattern). So as to be imprintable with the projected pattern, the upstream-facing surface of the substrate 139 is coated with a suitable "resist."

In the system 110 of Fig. 1B at least one multilayer-film optical element as described above is included in at least one of the illumination -optical system 127, the reticle 133, and the projection-optical system 137.

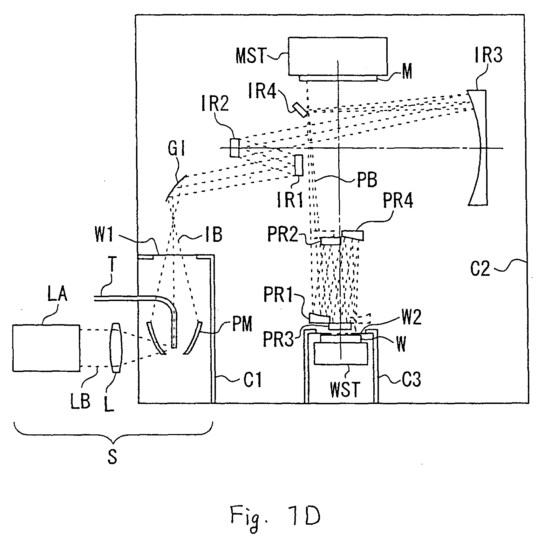

Fig. 1D shows another embodiment of an X-ray (specifically EUV) microlithography system utilizing one or more multilayer-film reflective optical elements as described herein and comprising a EUV source S, an illumination-optical system (comprising elements GI and IR1-IR4), a reticle stage MST for holding a reticle M, a projection-optical system (comprising elements PR1-PR4) and a substrate stage WST for holding a substrate W (such as a semiconductor wafer).

The EUV source S generates an illumination beam IB of EUV light. To such end, a laser LA generates and directs a high-intensity laser beam LB (near-IR to visible) through a lens L to the discharge region of a nozzle T that discharges a target substance such as xenon. The irradiated target substance forms a plasma that emit photons of EUV light that constitute the illumination beam IB. The illumination beam IB is reflected by a parabolic multilayer-film mirror PM to a window W1. The EUV source S is contained in a chamber C1 that is evacuated to a suitably high vacuum by means of a vacuum pump (not shown). The illumination beam IB passes through the window W1 to the interior of an optical-system chamber C2.

The illumination beam IB then propagates to the illumination -optical system comprising mirrors GI, IR1, IR2, IR3 and IR4. The mirror GI is a grazing-incidence mirror that reflects the grazing-incident illumination beam IB from the EUV source S. (Alternatively, the mirror GI can be a multilayer-film mirror.) The mirrors IR1, IR2, IR3 and IR4 are multilayer-film mirrors each including a surface multilayer film exhibiting high reflectivity to incident EUV radiation, as described elsewhere herein. The illumination-optical system also comprises a filter (not shown) that is transmissive only to EUV radiation of a prescribed wavelength. The illumination-optical system directs the illumination beam IB, having the desired wavelength, to a selected region on the reticle M. The reticle M is a reflective reticle including a multilayer film. The beam reflected from the reticle M carries an aerial image of the illuminated region of the reticle M; hence the reflected beam is termed a patterned beam.

The protection-optical system comprises multiple multilayer-film mirrors PR1, PR2, PR3 and PR4 that collectively project an image of the illuminated portion of the reticle M onto a corresponding location on the substrate W. Thus, the pattern defined by the reticle M is transfer-exposed onto the substrate W. Note that several of the mirrors PR1-PR4 (specially the mirrors PR1 and PR4) have a cutout allowing the patterned beam unobstructed passage in the projection -optical system. So as to be imprintable with the projected pattern, the substrate W is coated with an exposure -sensitive resist. Since EUV radiation is absorbed and attenuated in the atmosphere, the environment in the optical - system chamber C2 is maintained at a suitably high vacuum (such as 10⁻⁵ Torr or less). Actual exposure of the substrate W can be performed in a "step-and-repeat," "step-and-scan," or pure s canning-exposure manner, or other suitable manner, all of which involving controlled movements of the reticle stage MST and substrate stage WST relative to each other as transfer-exposure of the pattern progresses. During exposure, the substrate W is situated in a separate chamber C3, termed a "substrate chamber" or "wafer chamber," that contains the substrate stage WST. As the pattemed beam PB enters the substrate chamber C3 from the optical-system chamber C2, the beam passes through a window W2.

Wavefront aberration must be controlled so as to satisfy a given specification but a wavefront aberration correction system of this invention can be used to a correct such wavefront aberration errors. Wavefront aberration can be measured either in situ or outside the system. A device for measuring wavefront aberration of a EUV projection-optical system is described, for example, in the U.S patent 6,266,389 issued July 24, 2001, which is herein incorporated by reference. The surface shape of a mirror is varied such that the measured wavefront aberration comes to satisfy the given specification but it is not necessary to vary the surface configurations of all of the mirrors. It is sufficient if the surface configuration of at least one of the mirrors is made adjustable. A method of obtaining the final surface configuration of the mirror from the measured wavefront aberration is also described in aforementioned U.S patent 6,266,389.

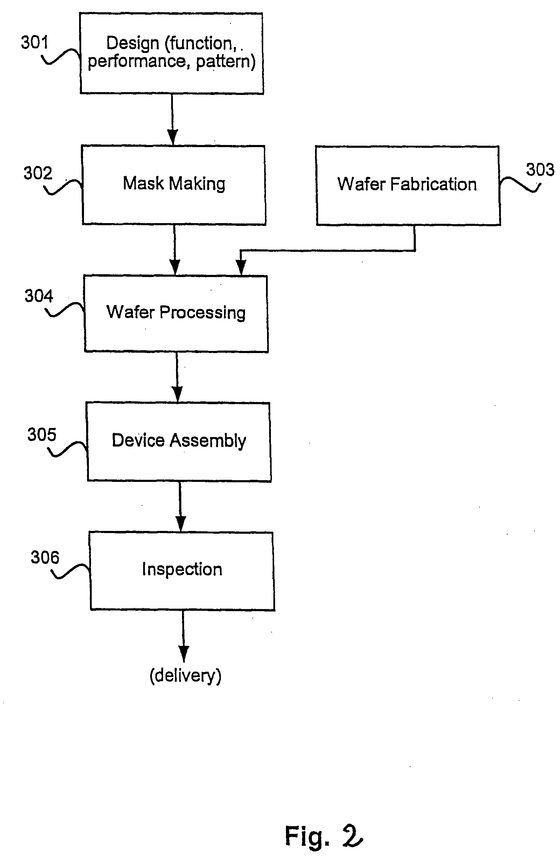

Further, semiconductor devices can be fabricated using the above described systems, by the process shown generally in Fig. 2. In step 301 the device's function and performance characteristics are designed. Next, in step 302, a mask (reticle) having a pattern is designed according to the previous designing step, and in a parallel step 303, a wafer is made from a silicon material. The mask pattern designed in step 302 is exposed onto the wafer from step 303 in step 304 by a photolithography system such as the systems described above. In step 305 the semiconductor device is assembled (including the dicing process, bonding process and packaging process), then finally the device is inspected in step 306.

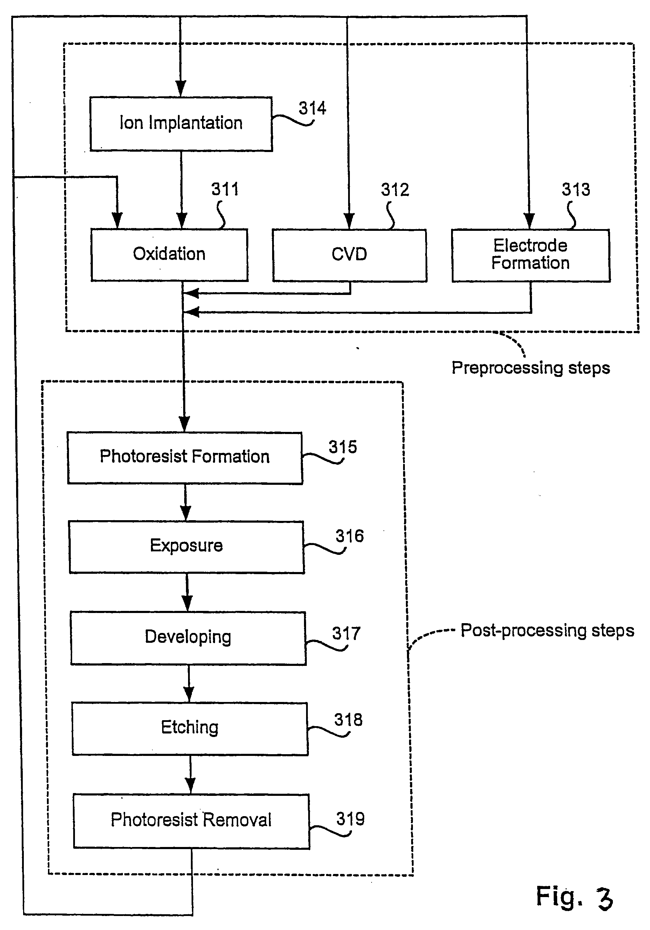

Fig. 3 illustrates a detailed flowchart example of the above-mentioned step 304 in the case of fabricating semiconductor devices. In step 311 (oxidation step), the wafer surface is oxidized. In step 312 (CVD step), an insulation film is formed on the wafer surface. In step 313 (electrode formation step), electrodes are formed on the wafer by vapor deposition. In step 314 (ion implantation step), ions are implanted in the wafer. The above mentioned steps 311-314 form the preprocessing steps for wafers during wafer processing, and selection is made at each step according to processing requirements.

At each stage of wafer processing, when the above-mentioned preprocessing steps have been completed, the following post-processing steps are implemented. During post-processing, initially, in step 315 (photoresist formation step), photoresist is applied to a wafer. Next, in step 316, (exposure step), the above-mentioned exposure device is used to transfer the circuit pattern of a mask (reticle) to a wafer. Then, in step 317 (developing step), the exposed wafer is developed, and in step 318 (etching step), parts other than residual photoresist (exposed material surface) are removed by etching. In step 319 (photoresist removal step), unnecessary photoresist remaining after etching is removed. Multiple circuit patterns are formed by repetition of these preprocessing and post-processing steps.

While this invention has been described in terms of several preferred embodiments, there are alterations, permutations, and various substitute equivalents which fall within the scope of this invention. It should also be noted that there are many alternative ways of implementing the methods and apparatuses of the present invention. It is therefore intended that the following appended claims be interpreted as including all such alterations, permutations, and various substitute equivalents as fall within the true spirit and scope of the present invention.

## Claims

1. A deformable mirror arrangement comprising:
a deformable mirror; and
a plurality of constraint mechanisms contacting said mirror at specified contact positions, at least three of said constraint mechanisms being rigid body servo control mechanisms each including a force actuator contacting said mirror at a corresponding one of said contact positions, a position sensor assisting to measure position of said mirror and a servo control unit for controlling said force actuator.

2. The deformable mirror arrangement of claim 1 wherein said rigid body servo control mechanisms are high-bandwidth servo control mechanisms.

3. The deformable mirror arrangement of claim 1 wherein said three rigid body servo mechanisms control degrees of freedom of said mirror along a Z-axis, around an X-axis and a Y-axis, said Z-axis being perpendicular to said mirror, said X-axis and said Y-axis being perpendicular to each other and to said Z-axis.

4. The deformable mirror arrangement of claim 3 wherein degrees of freedom of said mirror along said X-axis, along said Y-axis and around said Z-axis are each controlled by a passive mechanical mount.

5. The deformable mirror arrangement of claim 3 wherein degrees of freedom of said mirror along said X-axis, along said Y-axis and around said Z-axis are each controlled by a flexure.

6. The deformable mirror arrangement of claim 1 further comprising a plurality of force actuators without servo control for adjusting deformation of said deformable mirror.

7. The deformable mirror arrangement of claim 3 wherein the three rigid body servo control mechanisms apply parallel constraints on said deformable mirror along said Z-axis.

8. The deformable mirror arrangement of claim 3 wherein each of the three rigid body servo control mechanisms and another corresponding one of said constraint mechanisms apply mutually perpendicular forces at a same position.

9. A method of controlling degrees of freedom of a deformable mirror, said method comprising the steps of:
providing a plurality of constraint mechanisms contacting said mirror at specified contact positions, at least three of said constraint mechanisms being rigid body servo control mechanisms each including a force actuator contacting said mirror at a corresponding one of said contact positions, a position sensor assisting to measure position of said mirror and a servo control unit for controlling said force actuator; and
operating said constraint mechanisms to control degrees of freedom of said deformable mirror.

10. The method of claim 9 wherein said rigid body servo control mechanisms are high-bandwidth servo control mechanisms.

11. The method of claim 9 wherein said three rigid body servo mechanisms control degrees of freedom of said mirror along a Z-axis, around an X-axis and a Y-axis, said Z-axis being perpendicular to said mirror, said X-axis and said Y-axis being perpendicular to each other and to said Z-axis.

12. The method of claim 11 wherein degrees of freedom of said mirror along said X-axis, along said Y-axis and around said Z-axis are each controlled by a passive mechanical mount.

13. The method of claim 11 wherein degrees of freedom of said mirror along said X-axis, along said Y-axis and around said Z-axis are each controlled by a flexure.

14. The method of claim 9 further comprising the step of controllingly deforming said mirror by means of a plurality of kinematic mounts without servo control.

15. A lithography system for projecting a pattern on a wafer by a projection beam by preliminarily determining a surface profile of the wafer on a stage and subsequently introducing the stage with the wafer into the projection beam, said lithographic system comprising:
an illumination souce;
an optical system including a deformable mirror assembly;
a reticle stage arranged to retain a reticle;
a working stage arranged to retain a workpiece; and
an enclosure that surrounds at least a portion of the working stage, the enclosure having a sealing surface;
wherein said deformable mirror assembly includes deformable mirror and a plurality of constraint mechanisms contacting said mirror at different contact positions, at least three of said constraint mechanisms being rigid body servo control mechanisms each including a force actuator contacting said mirror at a corresponding one of said contact positions, a position sensor for detecting the corresponding contact position and a servo control unit for controlling said force actuator.

16. An object manufactured with the lithography system of claim 15.

17. A wafer on which an image has been formed by the lithography system of claim 15.

18. A method for making an object using a lithography process, wherein the lithography process utilizes a lithography system as recited in claim 15.

19. A method for patterning a wafer using a lithography process, wherein the lithography process utilizes a lithography system as recited in claim 15.
